# EUROPEAN PATENT APPLICATION

(11) **EP 1 796 026 A1**
(43) Date of publication of application: **13.06.2007**
(21) Application number: 06253040.7
(22) Date of filing: 13.06.2006
(51) Int. Cl.: G06K 19/077, C09J 9/02, H01L 21/60, H01R 4/04, H05K 3/32

(54) **A radio frequency device**

(30) Priority: 08.12.2005 US 297705
(71) Applicant: NRC International Inc., Dayton, Ohio 45479 (US)
(72) Inventor: Roth, Joseph D., Springboro, Ohio 45066 (US); Keeton, Mark E., Kettering, Ohio 45429 (US)
(74) Representative: Williamson, Brian

(57) **Abstract**

A wireless radio frequency device (10) includes: a substrate (14); a conductive adhesive (12) adhered to the substrate; and an integrated circuit (16) coupled to the conductive adhesive. The conductive adhesive is configured to function as an antenna. This allows the integrated circuit to receive and transmit radio frequency signals via the conductive adhesive.

## Description

The present invention relates generally to a wireless communications device, and, more particularly, to a radio frequency device.

Wireless communications devices, including wireless memory devices for storing and retrieving data, such as radio frequency identification ("RFID") transponders, are generally known in the art. RFID transponders are commonly found in the form of RFID labels.

A typical RFID label includes an inlay disposed between the face stock and liner of a typical two-ply label. The inlay includes an integrated circuit coupled to an antenna, both of which are mounted on a substrate. RFID inlays are typically produced with either a continuous metal strip or a conductive ink antenna. The integrated circuit is equipped with an interposer (commonly referred to as a strap), which connects the integrated circuit to the antenna. The interposer makes an electrical connection to pads on the integrated circuit and creates leads that are bonded to the antenna.

Generally, RFID labels are manufactured in two discrete steps - first the inlays are produced and then the inlays are converted into individual RFID labels. The inlay production starts with a web of substrate. The substrate can accommodate multiple inlays across its width, and many multiple inlay sets along its length. The web of substrate provides a W x N array (where W is typically 10 or less, and where N is very large, typically of the order of a thousand) of discrete label locations. An antenna is applied to each discrete location either by printing in the case of a conductive ink antenna or etching in the case of the metal strip antenna. An integrated circuit is then applied to each discrete label location where it is attached to one of the antennas with epoxy or some other adhesive. The web of finished inlays is then stored as a roll.

The finished inlays are then converted into RFID labels. Typically, the converting of the inlays starts with a web of standard two-ply pressure sensitive label material which comprises a facestock portion, a release liner portion and pressure sensitive adhesive which releasably adheres the two portions together. The pressure sensitive label material is first de-laminated such that the liner is separated from the facestock and the adhesive. Pressure sensitive adhesive is then applied to the liner. Individual RFID inlays are then separated from the roll of inlays and are placed directly on the adhesive thereby releasably adhering them to the liner. The liner and facestock are then re-laminated, making a continuous web of facestock, RFID inlays and liner. The facestock is then die-cut into discrete RFID labels, each having one inlay.

The resulting RFID labels are used in a variety of diverse industries. Among their many uses, RFID labels are used in systems for inventory management, asset tracking, security access, factory automation, and automotive toll debiting.

One of the barriers to further expanding the use of RFID labels is the high cost per label. Therefore, there exists a need in the art to produce a lower cost label.

According to a first aspect of the present invention there is provided a radio frequency device comprising: a substrate; a conductive adhesive adhered to the substrate and configured to function as an antenna; and an integrated circuit electrically coupled to the conductive adhesive and operable to receive and transmit radio frequency signals using the conductive adhesive as an antenna.

The substrate may be any suitable form factor and may comprise, *inter alia,* paper, synthetic fiber or film, product packaging, a smart card, a key fob, electronic surveillance label, a textile or any portion thereof. Preferably, the substrate comprises flexible label stock that has a printable side and a back side to which the adhesive and integrated circuit can be mounted.

Conveniently, the conductive adhesive comprises a base adhesive doped with conductive material. The base adhesive may be acrylic, epoxy, wax or any other suitable adhesive. Preferably, the base adhesive is a pressure sensitive acrylic adhesive. The base adhesive may be doped with metal, conductive polymers, conductive carbons, graphite or any other suitable conductive material. The conductive material may be in the form of flakes, beads, particles or any other suitable form.

The radio frequency device may also include a liner, wherein the conductive adhesive adheres the substrate to the liner. The liner and the substrate protect the integrated circuit from the surrounding environment. Preferably the liner is releasably adhered to the substrate, such that the liner can be peeled away.

The radio frequency device may also include a second adhesive for more securely binding the integrated circuit to the substrate.

According to a second aspect of the present invention there is provided a method of manufacturing a wireless radio frequency device, the method comprising: (i) applying a conductive adhesive in the configuration of an antenna to a substrate; and (ii) connecting a integrated circuit to the conductive adhesive such that the integrated circuit is operable to receive and transmit radio frequency signals via the conductive adhesive.

Applying conductive adhesive may further comprise tuning the wireless radio frequency device by applying the conductive adhesive in a predetermined configuration.

The method of manufacturing a wireless radio frequency device may further comprise applying a liner to the conductive adhesive.

According to a third aspect of the present invention, a method of processing a radio signal is provided. The method includes: (i) receiving a radio signal via conductive adhesive if the form of an antenna; (ii) generating a response to the radio signal; and (iii) transmitting the response to the radio signal via the conductive adhesive.

Embodiments of the present invention will now be described, by way of example, with reference to the accompanying drawings, in which:
FIGS. 1A, C and B are diagrams of a wireless radio frequency device in accordance with an embodiment of the invention;
FIGS. 2A and B are diagrams of the wireless radio frequency device of FIG. 1, mounted on a liner;
FIG. 3 is a flow chart illustrating the process of manufacturing the wireless radio frequency device of FIGS. 2A and B; and
FIG. 4 shows a roll of RFID labels produced by the process of FIG. 3.

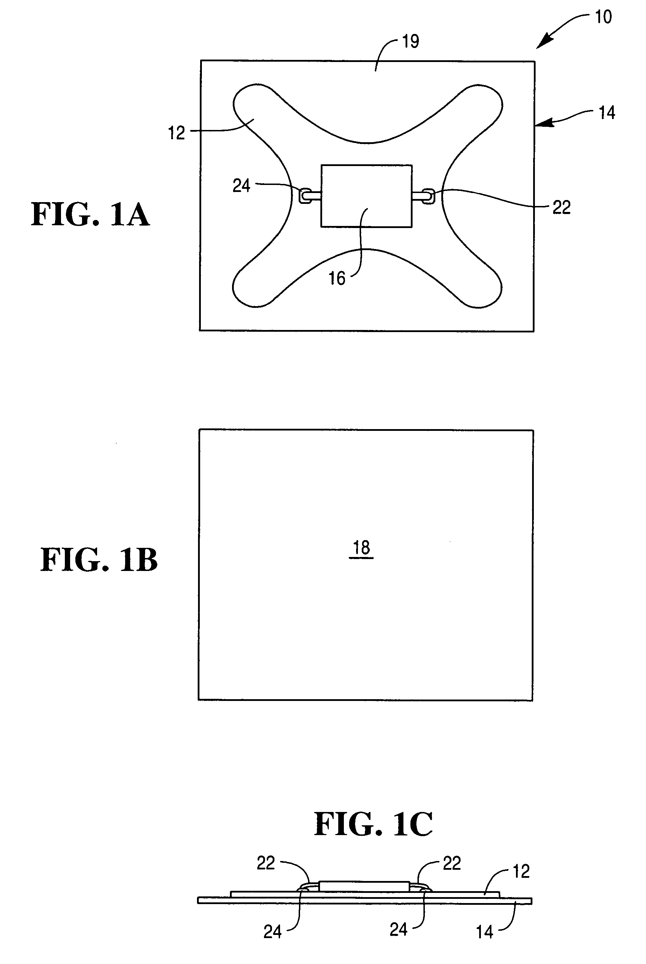

Referring to FIGS. 1A, 1B and 1C there is shown a schematic diagram of a radio frequency device 10, in the form of a RFID label, in accordance with an embodiment of the present invention. The RFID label 10 includes conductive adhesive 12 adhered to a substrate, in the form of flexible label stock 14, and an integrated circuit 16 electronically coupled to the conductive adhesive 12.

On one side of the flexible label stock 14 is a printable face 18 and on the reverse side 19 of the flexible label stock 14 the conductive adhesive 12 and the integrated circuit 16 are mounted. In this embodiment, the substrate 14 is flexible label stock in the form of paper, though depending on the intended use of the RFID label 10 other form factors may be more appropriate.

The integrated circuit 16 is provided with an interposer 22 (commonly referred to as a strap) which forms an electrical connection between chip and the conductive adhesive 12 enabling the integrated circuit 16 to receive and transmit radio frequency signals via an antenna formed by the conductive adhesive 12.

The operating frequency of the RFID label 10 is a function of the configuration of the conductive adhesive 12 on the flexible label stock 14. While, FIG. 1 shows the conductive adhesive in one configuration, there are literally an infinite number of possible configurations that may be used. It will be appreciated that the antenna formed by the conductive adhesive 12 is tuned to a desired frequency by selecting the appropriate configuration.

The integrated circuit 16, including the interposer 22, is secured to the flexible label stock 14 by the conductive adhesive 12. However, when a pressure sensitive conductive adhesive is used, it is preferable to use a small amount of conductive epoxy 24 to more securely adhere the integrated circuit 16 in place. Typically this will be accomplished by using the conductive epoxy 24 to secure the interposer 22 to the flexible label stock 14.

Various types of adhesives, such as acrylic based, wax based, and epoxy based adhesives, may be used for the conductive adhesive 14. Preferably, the adhesive used will be a pressure sensitive adhesive. It will be appreciated by using a pressure sensitive adhesive the RFID label 10 can be releasable adhered to a release liner during production and then later peeled from a that release liner and applied to an article of commerce.

Normally, the base adhesive chosen to be used in the conductive adhesive 12 will not naturally be conductive. For instance, an acrylic based adhesive will usually have an electrical resistance sufficiently high such that it acts as an insulator. In order to make the non-conductive base adhesive conductive, it is doped with one or more conductive materials, such as silver particles. Ideally the conductive adhesive will have a resistance level of 15-30 µOhms per square; however, various other embodiments may use conductive adhesives that have a resistance level that fall outside of this range.

It will be appreciated that adhesive must be tailored to the intended use of the tag. The environment in which the tag will operate is an important factor in selecting the appropriate adhesive and conductive material. For example, certain acrylics lose their tack and/or become very brittle in cold environments. Thus, an adhesive appropriate for cold temperatures should be selected when a tag is intended for use in a cold environment, such as a refrigerated warehouse or storage unit.

It will also be appreciated that the conductivity of the conductive adhesive is a function of both the base adhesive and the type and quantity of conductive material with which the base adhesive is doped. Therefore, if a different adhesive is selected for use in the label, it may be necessary to adjust the amount and/or type of conductive material.

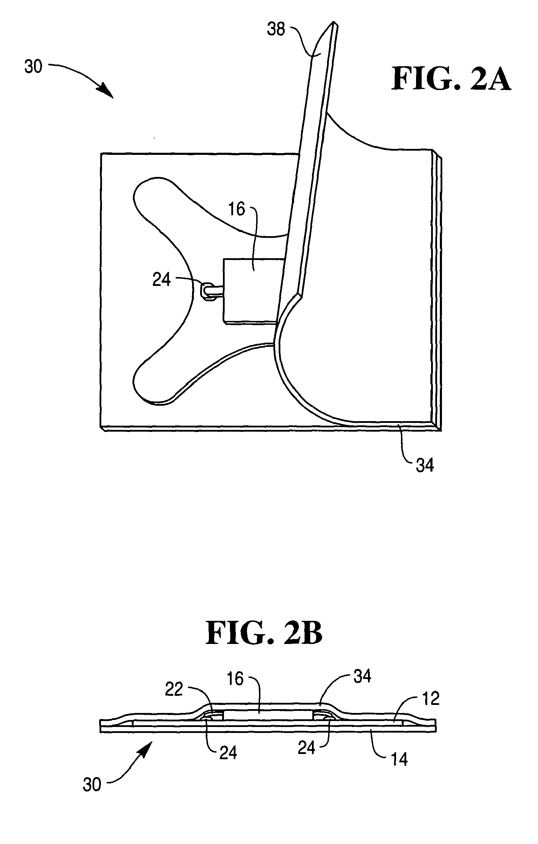

FIG. 2A and 2B show RFID label 30, which includes the RFID label 10 mounted on a release liner 34. The release liner 34 has a silicone layer 38 to which the RFID label 10 releasably adheres via the conductive adhesive 12. It will be appreciated that the RFID label 10 can be peeled from the release liner 34 and adhered to an object, such as piece of merchandise.

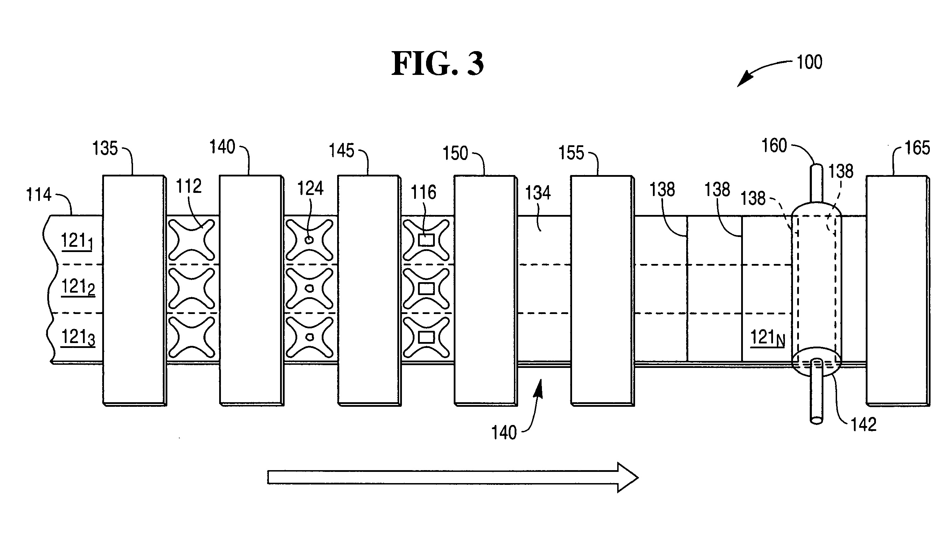

FIG. 3 illustrates a web 114 of label stock being transported over a process area 100 having a plurality of stations. Each of these stations performs a particular step in the manufacturing process of RFID labels 30.

The web 114 of label stock has a printable side that corresponds to the printable face 18 of the flexible label stock 14 and a reverse side that corresponds to the reverse side 19 of the flexible label stock 14. The web 114 of label stock provides a 3 x N array (where N is very large, typically of the order of a thousand) of discrete locations 121_{1..N} (the boundaries of which are indicated by dotted lines), each of which will form an individual RFID label 30.

Typically, the manufacturing process begins by feeding the web 114 of label stock into the process area 100. The web 114 first arrives at antenna station 135. As the web passes through the antenna station 135 conductive adhesive 112 is applied to each discrete location 121 forming an antenna thereon.

From the antenna station 135 the web 114 is transported along the process area 100 to the adhesive station 140. As the web 114 passes through the adhesive station 140 a spot of epoxy 124 is applied to each discrete location 121.

From the adhesive station 140 the web 114 is transported along the process area to the integrated circuit station 145 where an integrated circuit 116 is applied to the conductive adhesive 112 and the epoxy 124.

From the integrated circuit station 145 the web 114 advances to a lamination station 150 where the web 114 is laminated to a liner web 134. It will be appreciated that the adhesive antennas 112 provide the necessary adhesive to laminate the liner web 134 to the web 114 of label stock thereby forming a two-ply web 140.

Once laminated the resulting two-ply web 140 is transported to a die-cutting station 155, where it receives a die-cut 138 across the width of the web between the discrete locations 121. Each die-cut allows the resulting FRID labels 30 to be easily separated from one another.

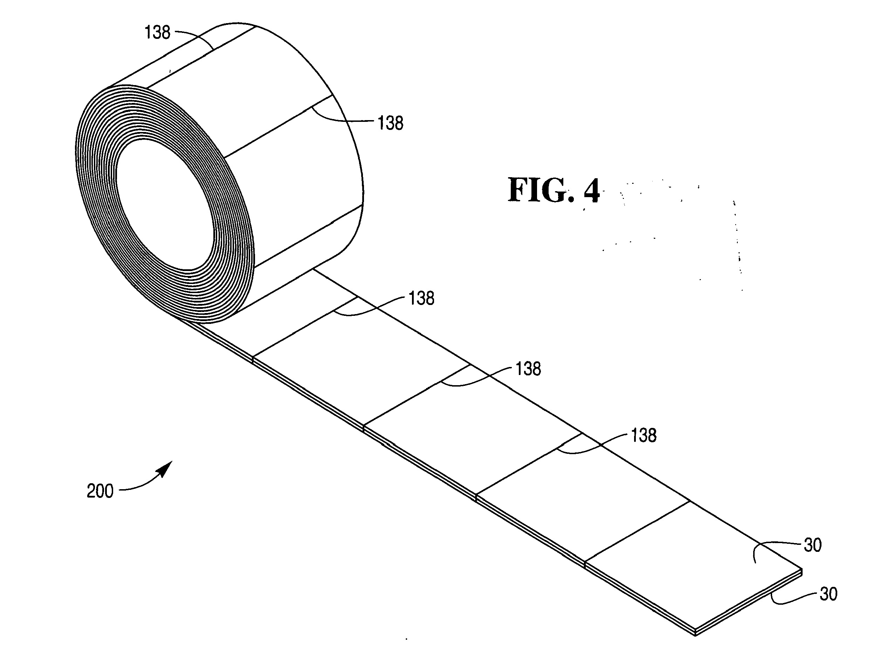

Once die-cut, the two ply web 140 advances to the rolling station 160, where the two-ply web 140 is formed into a roll 142. The resulting roll 142 then advances to cutting station 165, where the roll 142 is cut into three individual rolls 200 of RFID labels 30, as shown in FIG. 4, each roll having a 1 x N array of RFID labels 30.

It will be appreciated that that process 100 does not require a separate production of inlays to render an RFID label, thereby greatly reducing the cost of production.

Various modifications may be made to the above described embodiments, within the scope of the present invention.

In the above embodiments, the substrate 14 was flexible label stock in the form of paper, however it will be appreciated that any suitable flexible label stock may be used, such as synthetic films or fibers. Moreover, depending on the intended use of the RFID label, form factors other than flexible label stock may be more appropriate. For example, in some embodiments form factors, such as product packaging, smart cards, a key fobs, electronic surveillance labels or permanent textile labels, may be more appropriate.

It will be appreciated that adhesives other than pressure sensitive adhesives may be used to form an antenna. In such cases, it may be of little or no benefit to use a secondary adhesive, such as epoxy 24, to secure the integrated circuit in place. Therefore, when a more permanent adhering adhesive is used for the antenna it may be advantageous not to use a second adhesive, as this reduces the complexity of the RFID label and removes a step in the production of the label.

In the embodiment of FIGS. 2A and 2B the liner 34, has a silicone release layer 38, however, in other embodiments the liner may have a release layer made of any material that enables a pressure sensitive adhesive to releasably adhere to it. Moreover, in some embodiments the conductive adhesive may permanently adhere the label stock to the liner, in which case no release layer is required.

In the above embodiments, the adhesive was doped with silver particles, however some embodiments may use various other metals, such as, aluminum, copper, gold and/or alloys thereof. Moreover, these metals may be in any of a variety of forms such as flakes, beads, particles or any other suitable form. It will also be appreciated that materials other than metal, such as conductive polymers, conductive carbons, and/or graphite, may be used to dope the adhesive.

In the above embodiments, the integrated circuit 16 had an interposer 22 and epoxy 24 was used to more securely fasten the interposer to the flexible label stock 14. However, in some embodiments no interposer is provided and in such cases a conductive epoxy may be applied directly to the body of the integrated circuit.

## Claims

1. A wireless radio frequency device comprising:
a substrate;
a conductive adhesive adhered to the substrate and configured to function as an antenna; and
an integrated circuit coupled to the conductive adhesive and operable to receive and transmit radio frequency signals via the conductive adhesive.

2. The wireless radio frequency device of claim 1, further comprising a liner, wherein the conductive adhesive adheres the liner to the substrate.

3. The wireless radio frequency device of claim 2, wherein the liner is releasably adhered to the substrate.

4. The wireless radio frequency device of claim 1, wherein the conductive adhesive is pressure sensitive adhesive.

5. The wireless radio frequency device of claim 4, wherein the pressure sensitive adhesive enables the radio frequency device to be adhered to an article of commerce.

6. The wireless radio frequency device of claim 4, further comprising a second adhesive which permanently adheres the integrated circuit to the substrate.

7. The wireless radio frequency device of any preceding claim, wherein the substrate comprises a facestock sheet having a printable side and back side, wherein the conductive adhesive and the integrated circuit are mounted on the back side of the facestock sheet.

8. The wireless radio frequency device of any preceding claim, wherein the conductive adhesive adheres the integrated circuit to the substrate.

9. The wireless radio frequency device of any preceding claim, wherein in the conductive adhesive is an acrylic based adhesive.

10. The wireless radio frequency device of any preceding claim, wherein in the conductive adhesive is an epoxy based adhesive.

11. The wireless radio frequency device of any preceding claim, wherein in the conductive adhesive is a wax based adhesive.

12. A method for producing a wireless radio frequency device, the method comprising:
applying a conductive adhesive in the configuration of an antenna to a substrate; and
connecting a integrated circuit to the conductive adhesive such that the integrated circuit is operable to receive and transmit radio frequency signals via the conductive adhesive.

13. The method of claim 12, further comprising applying a liner to the conductive adhesive.

14. The method of clam 12, further comprising tuning the wireless radio frequency device by applying the conductive adhesive in a predetermined configuration.
